Europäisches Patentamt

(19) European Patent Office

Office européen des brevets

(11) EP 0 940 849 A1

(12) EUROPEAN PATENT APPLICATION

(43) Date of publication:
08.09.1999 Bulletin 1999/36

(51) Int. Cl.$^6$: H01L 23/66, H01L 23/552

(21) Application number: 98870046.4

(22) Date of filing: 05.03.1998

(84) Designated Contracting States:
AT BE CH DE DK ES FI FR GB GR IE IT LI LU MC
NL PT SE
Designated Extension States:
AL LT LV MK RO SI

(71) Applicant:
INTERUNIVERSITAIR MICRO-ELEKTRONICA
CENTRUM VZW
3001 Heverlee (BE)

(72) Inventors:
• Koldiaev, Viktor
  3001 Leuven (BE)
• Deferm, Ludo
  3581 Beverlo (BE)

(74) Representative:
Van Malderen, Michel et al
Office van Malderen
Place Reine Fabiola 6/1
1083 Bruxelles (BE)

(54) A low-loss conductive pattern on a substrate and a method for fabrication thereof

(57) In the present invention a low-loss conductive pattern, like e.g. a spiral inductor or an interconnect line is disclosed and a method of fabricating such a conductive pattern. To overcome the problem of the strong (even resonance) frequency dependence of the main parameters of a conductive pattern, like e.g. interconnects lines and spiral inductors, on a lossy substrate in a predetermined frequency region, a semi-transparent screening layer and an electrical contact for applying a substantially zero potential to said layer are introduced in or on said lossy substrate.

Figure 3

EP 0 940 849 A1

## Description

FIELD OF THE INVENTION

The present invention is related to a low-loss conductive pattern, like e.g. a spiral inductor or an interconnect line, and a method of fabricating said conductive pattern. Particularly the present invention yields a low-loss conductive pattern on a lossy substrate, like e.g. a doped silicon substrate, in a specific predetermined frequency region. Conductive patterns in general are key components in the design and the manufacture of integrated circuits. They are used frequently in a wide range of applications, especially for telecom applications, and can be inserted in MCM's as well as fully integrated in existing semiconductor processes.

BACKGROUND OF THE INVENTION

It is common knowledge that when one studies the signal behaviour of an arbitrary conductive pattern on an arbitrary substrate versus frequency, one will be confronted with signal losses and distortions. The main reasons for losses in these conductive patterns are conductor losses, radiation losses, mismatch losses, dielectric losses, hysteresis losses and substrate losses. Of particular interest are the conductor losses and the substrate losses.

Conductor losses are caused by the resistive nature of the conductive pattern. At microwave frequencies the signal flow is concentrated at the surface of the conductive pattern. The current density is maximum at the surface of the conductive pattern and decreases exponentially with depth in the conductive pattern. The penetration depth of the current is characterised by the skin depth, which is the depth in the conductive pattern where the current density is decreased to 1/e (which is about 30%) of its surface value. In other words, if the skin depth $\delta$ equals the thickness of the conductive pattern, then the current density at the backside of the conductive pattern is about 30% of its surface value. The skin depth is defined as follows:

$$\delta = \sqrt{\frac{\rho}{\pi f \mu_o \mu_r}}$$

From this definition one can conclude that the skin depth increases if the specific resistance of the conductive pattern, $\rho$, increases and decreases with increasing frequency, f, while the relative permeability $\mu_r$ of the conductive pattern equals 1 for nonferromagnetic materials. Important is the frequency at which the skin depth equals the thickness of the conductive pattern, hereafter called the skin depth frequency, $f_s$. For example, aluminum conductive patterns have a skin depth frequency in the range from about 1 GHz for a thickness of about 3 $\mu$m to about 10 GHz for a thickness of about 1 $\mu$m.

Consequently the quasi-static approach provides a good approximation for the impedance of such an aluminum conductive pattern substantially below the skin depth frequency resulting in an essentially frequency independent behaviour of the real part of the impedance of the conductive pattern. The quasi-static approach is no longer valid at frequencies around and beyond $f_s$ due to the conductor losses caused by the skin effect. At these frequencies, the real part of the impedance of the conductive pattern increases with increasing frequency.

Substrate losses are caused due to the penetration of the electrical field, induced by the signal flow through a conductive pattern, into the substrate. The frequency regime at which these losses occur is strongly correlated with the resistivity and the thickness of the substrate. To determine this frequency regime, two critical frequencies are of major importance: the so-called Maxwell-Wagner relaxation frequency, $f_{MW}$, and the substrate relaxation frequency, $f_{sr}$. The Maxwell-Wagner relaxation frequency is inversely proportional to the product of the substrate resistance and the capacitance of the insulator between the conductive pattern and the substrate. The substrate relaxation frequency is inversely proportional to the product of the permittivity and the resistivity of the substrate. The meaning of these critical frequencies can be explained as follows:

a) at frequencies below $f_{MW}$ the permittivity of the substrate is purely imaginary and reveals a lossy behaviour,
b) at frequencies between $f_{MW}$ and $f_{sr}$ the permittivity comprises a real and an imaginary part and both parts reveal a lossy behaviour which peaks at a frequency between $f_{MW}$ and $f_{sr}$,
c) at frequencies beyond $f_{sr}$ the permittivity is purely real and reveals a non-lossy dielectric behaviour.
d) From a practical point of view, at frequencies between $f_{MW}$ and $f_{sr}$ the transition behaviour of the capacitance of a conductive pattern with respect to the ground plane occurs. Particularly, at frequencies below $f_{MW}$ said capacitance is determined with respect to the interface between the substrate and the insulating layer, while at frequencies beyond $f_{sr}$ said capacitance is determined with respect to the substrate contact at the backside of the substrate.

However this explanation is only applicable at frequencies below the skin depth frequency of the substrate, and consequently if $f_s$ is greater then $f_{sr}$.

If the substrate and the conductive pattern are chosen such that said conductive pattern is operated in either one of the aforementioned skin-effect mode or the lossy-substrate mode in a predetermined frequency region, then one can easily predict the behaviour of said conductive pattern versus frequency. However, when the predetermined frequency region is in the transition region between the skin-effect mode and the lossy-substrate mode, then the predictions of the frequency behaviour of said conductive pattern become very complicated and unreliable.

AIM OF THE INVENTION

To overcome the problem of the strong (even resonance) frequency dependence of the main parameters of a conductive pattern, like e.g. interconnects lines and spiral inductors, on a lossy substrate in a predetermined frequency region, the use of semi-transparent screening layers is suggested. Moreover, these screening layers can be introduced to suppress the cross-talk between different interconnect lines as well as between an interconnect line and the substrate as well as between different parts of a substrate as e.g. a substrate with analog and digital parts. Furthermore, by introducing these screening layers the quality factor (Q) of a conductive pattern, i.e. an inductor, can be improved in a predetermined frequency region.

SUMMARY OF THE INVENTION

In an aspect of the invention a device is disclosed for reducing the dispersion of frequency characteristics of a conductive pattern in a predetermined frequency region comprising:

a conductive pattern;
a lossy substrate, said conductive pattern being formed on said substrate;
at least one insulating layer between said conductive pattern and said substrate; characterised in that, said device further comprises a semi-transparent screening layer and an electrical contact for applying a substantially zero potential to said layer. Said insulating layer can be at least one oxide layer or a nitride layer or a layer of a low permittivity dielectric like e.g. a BCB layer or a SILK layer or a combination of these layers. Said device further comprises a semi-transparent screening layer located in the substrate near or at the interface of said substrate and said insulating layer and an electrical contact to said screening layer for applying a substantially zero potential. Said screening layer can be any highly doped layer, i.e. a highly doped buried layer or a highly doped surface layer, formed in the substrate. Furthermore, the thickness of said screening layer should be chosen such that its skin depth frequency is beyond a predetermined frequency region in order to guarantee transparency for the magnetic field, therefore said thickness is typically in the range from 0.1 $\mu$m to 2 $\mu$m.

In an embodiment of the invention a device is disclosed for reducing the dispersion of frequency characteristics of a conductive pattern in a predetermined frequency region comprising:

a conductive pattern;
a lossy substrate, said conductive pattern being formed on said substrate;
at least one insulating layer between said conductive pattern and said substrate; characterised in that, said device further comprises a semi-transparent screening layer and an electrical contact for applying a substantially zero potential to said layer. Said screening layer can be any highly conductive thin layer formed on the lossy substrate like e.g. a thin metal layer or a highly doped polysilicon layer. Furthermore, the thickness of said screening layer should be chosen such that its skin depth frequency is beyond a predetermined frequency region in order to guarantee transparency for the magnetic field, therefore in case a metal layer is used as a screening layer, said thickness is typically in the range of 0.3 $\mu$m or below.

In an aspect of the invention a method is disclosed for shifting the frequency transition region of a conductive pattern beyond a predetermined frequency region, said conductive pattern being formed on a lossy substrate with at least one insulating layer inbetween said conductive pattern and said substrate, wherein said shift of said transition region is accomplished by the introduction of a semi-transparent screening layer, said screening layer being located near or at the interface of said substrate and said insulating layer, and wherein a substantially zero potential is applied to said screening layer. Said conductive pattern is formed on a lossy substrate with at least one insulating layer inbetween said conductive pattern and said substrate. Said insulating layer can be at least one oxide layer or a nitride layer or a layer of a low permittivity dielectric like e.g. a BCB layer or a SILK layer or a combination of these layers. Said shift of the transition region is accomplished by the introduction of a semi-transparent screening layer, i.e. a layer which forms an electrical wall and therefore a screening layer for the electric field and which is transparent for the magnetic field, in said substrate. Said screening layer is located in the substrate near or at the interface of said substrate and said insulating layer and an electrical contact is provided to said screening layer for applying a substantially zero potential. Said screening layer can be any highly doped layer formed in the substrate. Furthermore, the thickness of said screening layer should be chosen such that its skin depth frequency is beyond a predetermined frequency region in order to guarantee transparency for the magnetic field. Said highly doped layer can be a highly doped buried layer or a highly doped surface layer.

According to the method of the present invention, alternatively said screening layer can be located on the substrate near or at the interface of said substrate and said insulating layer and an electrical contact is provided to said screening layer for applying a substantially zero potential. Said screening layer can be any highly conductive layer formed on said substrate. Furthermore, the thickness of said screening layer should be chosen such that its skin depth frequency is beyond a predetermined frequency region in order to guarantee transparency for the magnetic field. In case said highly conductive layer is a highly doped polysilicon layer, its thickness is typically in the range from 0.1 $\mu$m to 1 $\mu$m, while in case said highly conductive layer is a thin metal layer, its thickness is typically in the range below 0.3 $\mu$m.

BRIEF DESCRIPTION OF THE DRAWINGS

Figure 1 depicts a conductive pattern comprising three metal fingers. In fig. 1 a) the capacitances of these fingers are indicated in the low-frequency limiting case, while in fig. 1 b) the capacitances of these fingers are indicated in the high-frequency limiting case.

Figure 2 a) depicts a schematic top view of a device comprising a conductive pattern, i.e. a spiral inductor, on a silicon wafer.

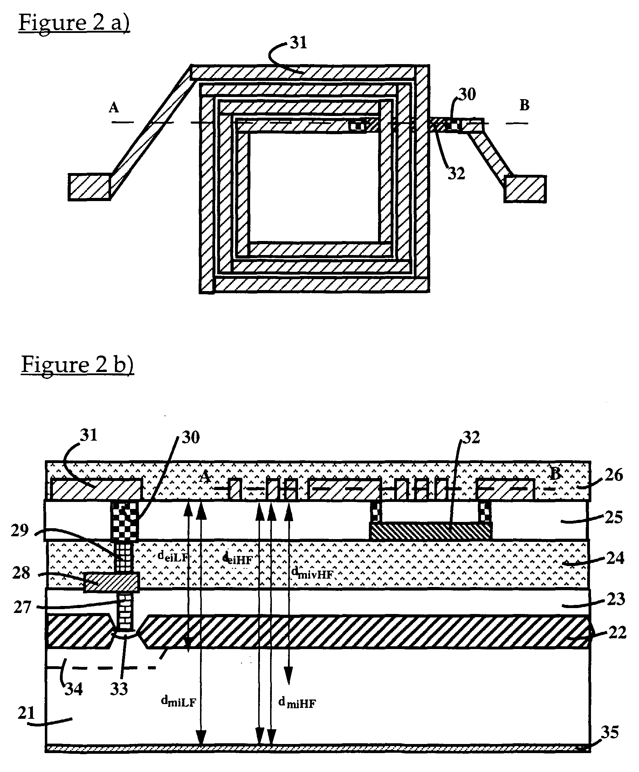

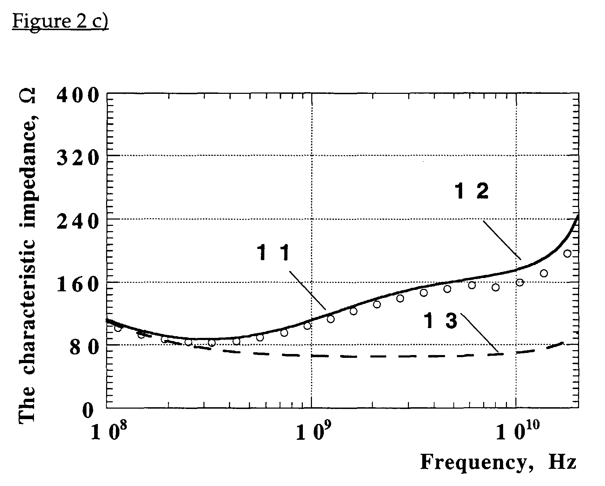

Figure 2 b) depicts a cross-section (from A to B as indicated in fig. 2 a))of a device comprising a conductive pattern, i.e. a spiral inductor, on a silicon wafer. The following geometrical parameters are indicated:

$d_{eiLF}$ : the distance from the inductor to the electrical wall (where the potential is zero) where the electric field (and the electric component of the electromagnetic energy) is kept at low frequencies
$d_{eiHF}$ is the same as $d_{eiLF}$ for the high frequency range (e.g. 1 GHz$<f<$10 GHz);
$d_{miLF}$: the distance from the inductor into the substrate where the magnetic field (and the magnetic component of the electromagnetic energy) is kept at low frequencies;
$d_{miHF}$ is the same as $d_{miLF}$ for the high frequency range;
$d_{mivHF}$ is the same as $d_{miLF}$ for the very high frequency range (skin effect in the substrate)

Figure 2 c) depicts, according to an embodiment of the invention, the characteristic impedance of a typical spiral inductor versus frequency. (11) is a measured curve (the symbols) of said inductor, said inductor being formed on a substrate without a semi-transparent screening layer, while (12) is a simulated curve of said inductor. (13) is a simulated curve of an inductor being formed on a substrate with a semi-transparent screening layer.

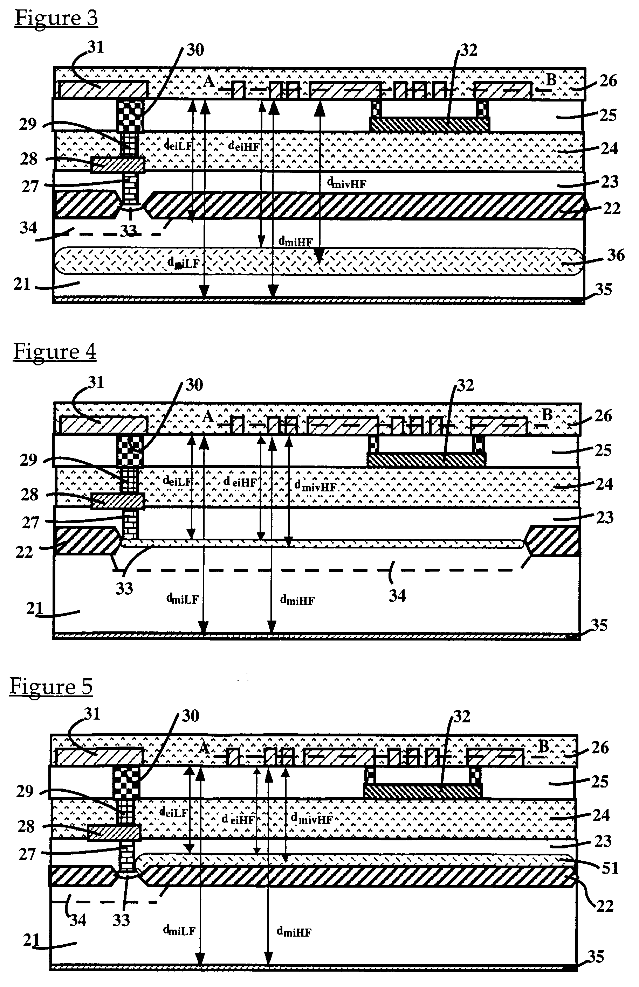

Figure 3 depicts a cross-section of a device comprising a conductive pattern, i.e. a spiral inductor, on a silicon wafer. According to an embodiment of the invention said device further comprises a highly doped p-type buried layer used as a semi-transparent screening layer. The same parameters as defined above in fig.2 are indicated in figure 3.

Figure 4 depicts a cross-section of a device comprising a conductive pattern, i.e. a spiral inductor, on a silicon wafer. According to an embodiment of the invention said device further comprises a highly doped p-type source/drain layer used as a semi-transparent screening layer. The same parameters as defined above in fig.2 are indicated in figure 4.

Figure 5 depicts a cross-section of a device comprising a conductive pattern, i.e. a spiral inductor, on a silicon wafer. According to an embodiment of the invention said device further comprises a highly doped p-type polysilicon layer used as a semi-transparent screening layer. The same parameters as defined above in fig.2 are indicated in figure 5.

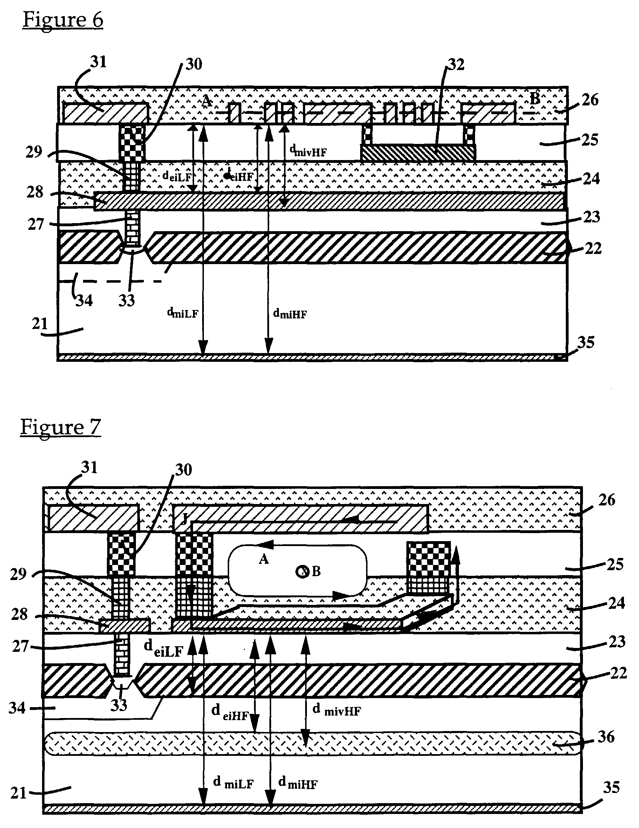

Figure 6 depicts a cross-section of a device comprising a conductive pattern, i.e. a spiral inductor, on a silicon wafer. According to an embodiment of the invention said device further comprises a very thin (first) metal layer, having a thickness of 0.3$\mu$m, used as a semi-transparent screening layer. The same parameters as defined above in fig.2 are indicated in figure 6.

Figure 7 depicts a cross-section of a device comprising a conductive pattern, i.e. a spiral inductor based on a coil structure, on a silicon wafer. According to an embodiment of the invention said device further comprises a highly doped p-type buried layer used as a semi-transparent screening layer. The same parameters as defined above in fig.2 are indicated in figure 7.

DETAILED DESCRIPTION OF THE INVENTION

In relation to the appended drawings the present invention is described in detail in the sequel. Several embodiments are disclosed. It is apparent however that a person skilled in the art can imagine several other equivalent embodiments or other ways of practising the present invention, the spirit and scope of the present invention being limited only by the terms of the appended claims.

When studying the frequency behaviour of a conductive pattern on a lossy substrate with an insulating layer inbetween said conductive pattern and said substrate several parameters are of importance and should be introduced first. These parameters can be the skin depth frequency of the conductive pattern, $f_{s,con}$ ,

the skin depth frequency of the substrate, $f_{s,sub}$ , the Maxwell-Wagner relaxation frequency, $f_{MW}$, and the substrate relaxation frequency, $f_{sr}$. The skin depth frequency of the conductive pattern, $f_{s,con}$ is determined by the thickness and resistivity of the conductive pattern, while $f_{s,sub}$ is determined by the thickness and resistivity of the substrate. The Maxwell-Wagner relaxation frequency, $f_{MW}$ depends amongst others on the resistivity and the thickness of the substrate and the thickness and permittivity of the insulating layer. The substrate relaxation frequency, $f_{sr}$ is determined by the permittivity and the resistivity of the substrate.

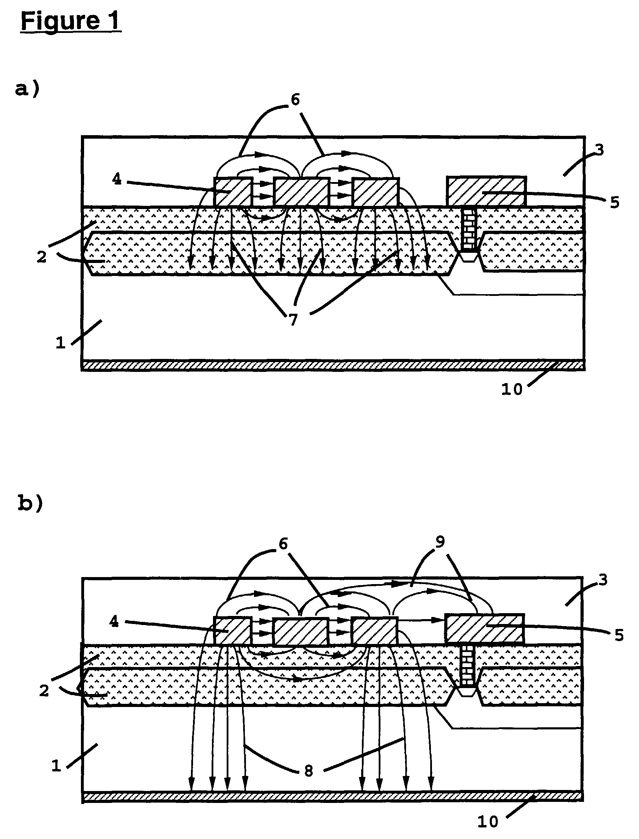

A problem can arise when the conductive patterns are formed on a lossy substrate like e.g. a semiconductive wafer, i.e. a silicon wafer, with an insulating layer, e.g. an oxide layer, between said conductive pattern and said substrate. Particularly, in figure 1 a conductive pattern (4) is depicted comprising three conductive fingers, wherein said pattern is isolated from the substrate (1) by two insulating layers (2) and said fingers are isolated one another by an intra-metal dielectric (3). Said substrate can be provided with a ground contact at its backside (10) and/or with a surface ground contact (5). Regardless of the precise substrate configuration, at frequencies substantially below the minimum of $f_{s,sub}$, $f_{sr}$, $f_{MW}$ and $f_{s,con}$ , said conductive pattern has a capacitance to the substrate (7) which is dependent on the main parameters of the insulating layer, i.e. its thickness and permittivity. In fact when a signal travels through a conductive pattern, the electrical wall, i.e. the location where the potential is zero, at these frequencies is located at about the interface between the substrate and the insulating layer (fig. 1 a)). At frequencies at about the Maxwell-Wagner relaxation frequency, $f_{MW}$ , i.e. the transition region, the electrical wall is shifted (fig. 1 b)) to the backside of the substrate, i.e. the electrical field extends through the whole substrate thereby leading to a decrease of the capacitance to the substrate (8), but an increase of the parasitic capacitance to the ground (9). In case the conductive pattern comprises parts which are located close one to another also the capacitance between said parts (6) increases. If this transition region coincides with a predetermined frequency region the main parameters of the conductive pattern are strongly frequency dependent which leads to a significant increase in loss, distortions and cross-talk. By the introduction of a semi-transparent screening layer, i.e. a layer which forms an electrical wall and therefore a screening layer for the electric field and which is transparent for the magnetic field, in or on said substrate the transition region can be shifted to higher frequencies, i.e. beyond a predetermined frequency region. Therefore, the transition region no longer coincides with the predetermined frequency region which leads to a predictable frequency behaviour of the main parameters of the conductive pattern. Consequently, the capacitance to the substrate is frequency independent because the ground is located at the screening layer instead of moving from the interface between the substrate and the insulating layer to the backside of the substrate. For the same reason, the parasitic capacitance as well as the capacitance between different parts of a conductive pattern are much smaller in the predetermined frequency region. Therefore cross-talk between the conductive pattern and the substrate as well as cross-talk between different parts of a conductive pattern or between different conductive patterns is significantly reduced.

As an example, let us consider as predetermined frequency region the frequency range between 1 GHz and 10 GHz, which is the typical range for the modern digital applications fabricated in CMOS technologies. Furthermore this range includes also most of the operating frequencies for modern analogue applications, particularly the telecommunication applications with operating frequencies in the range between about 1 GHz and about 4 GHz, fabricated in MOS, Bipolar or BiCMOS technologies. When one wants to fabricate circuits for these applications on a silicon substrate, the choice of the resistivity of the substrate is crucial because one wants to assure a predictable frequency behaviour and minimize losses of the conductive patterns, e.g. interconnect lines or spiral inductors, processed on this substrate in a predetermined frequency region. This means that one wants to avoid that the transition region between the skin-effect mode and the lossy-substrate mode of those conductive patterns coincides with a predetermined frequency region. Remark however that the present invention is not limited to the frequency region between 1 GHz and 10 GHz as predetermined frequency region.

Further according to this example and for the purpose of teaching, let us consider a typical substrate and a typical conductor as used in MOS technology. As a substrate a silicon wafer is chosen with a specific resistance of 20 $\Omega$cm and a thickness of 700 um, while as a conductor an aluminum interconnect line is chosen with a thickness of 1 um. A silicon oxide layer of about 3 um is formed inbetween said conductor and said substrate. The specific resistance of aluminum is about 2.73 x $10^{-6}$ $\Omega$cm, yielding a skin depth frequency $f_s$ of about 6.9 GHz. The relevant parameters of the substrate are the skin depth frequency $f_s$, which is about 1.03 THz, the substrate relaxation frequency $f_{sr}$ of about 7.56 GHz and the Maxwell-Wagner relaxation frequency of about 1 GHz. Consequently the transition region between the skin-effect mode and the lossy-substrate mode of the aluminum line coincides with a predetermined frequency region, which is highly undesirable because the predictions of the behaviour of interconnect lines and spiral inductors in a predetermined frequency region are very complicated and unreliable. Moreover the interconnect lines and spiral inductors in the predetermined frequency region will be rather lossy because in this region the capacitance between the interconnect line and the substrate decreases while the parasitic capacitance between the input and output ports increases. Furthermore there is an increase of the parasitic series resistance.

In an aspect of the invention, to overcome the problem of the strong (even resonance) frequency dependence of the main parameters of a conductive pattern, like e.g. interconnects lines and spiral inductors, on a lossy substrate in a predetermined frequency region, the use of semi-transparent screening layers is suggested. Moreover, these screening layers can be introduced to suppress the cross-talk between different interconnect lines as well as between an interconnect line and the substrate as well as between different parts of a substrate as e.g. a substrate with analog and digital parts. In fact these layers are introduced to shift the transition region between the skin-effect mode and the lossy-substrate mode of a conductive pattern outside a predetermined frequency region. Preferably the predetermined frequency region is the region ranging from 1 GHz to 10 GHz. Actually, the characteristic impedance and the propagation constant of a conductive pattern are frequency independent in a range from about 1 GHz to about 100 GHz, except potentially for the narrow frequency range in the vicinity of the self-resonance frequency, said self-resonance frequency being inversely proportional to the square root of the product of the total inductance and the total parasitic capacitance of said conductive pattern.

The aforementioned semi-transparent screening layers are thin conductive layers located in the vicinity of the interface between the substrate and the insulating layer. In order to provide a good electric screening, the resistivity of said semi-transparent screening layer should be sufficiently low. Therefore highly doped layers can be formed in or on the substrate with a resistivity typically about $10^{-3}$ $\Omega$cm or below $10^{-3}$ $\Omega$cm. Examples of such layers are a highly doped surface layer as e.g. the source/drain layer in a MOS technology, a highly doped buried layer or a highly doped polysilicon layer. Also metal layers can be used as e.g. the first level metallisation layer in a MOS or bipolar technology. Besides providing a good electric screening said semi-transparent screening layer should also be thin enough to guarantee transparency for the magnetic field in a predetermined frequency region. When highly doped layers in or on the substrate are chosen as semi-transparent screening layers, a typical thickness should be in the range from 0.1 $\mu$m to 2 $\mu$m, while for metal layers as semi-transparent screening layers, a thickness typically about 0.3 $\mu$m or below is requested.

According to the present invention a device is disclosed for reducing the dispersion of frequency characteristics of a conductive pattern in a predetermined frequency region comprising:

a conductive pattern;
a lossy substrate, said conductive pattern being formed on said substrate;

at least one insulating layer between said conductive pattern and said substrate; characterised in that, said device further comprises a semi-transparent screening layer and an electrical contact for applying a substantially zero potential to said layer. Said substrate can be a semiconductive wafer or slice, as e.g. a doped silicon wafer with or without a doped epitaxial layer or a doped GaAs wafer or a doped SiGe wafer. Said substrate has a resistivity which can be between 10 m$\Omega$cm and 1 k$\Omega$cm, but preferably between 10 $\Omega$cm and 100 $\Omega$cm. Said insulating layer can be at least one oxide layer or a nitride layer or a layer of a low permittivity dielectric like e.g. a BCB layer or a SILK layer or a combination of these layers. Said conductive pattern can be composed of a metal like e.g. Al or Cu or Au or an alloy of one of the aforementioned metals. Said conductive pattern can also comprise a highly conductive layer, e.g. a metal layer, and a barrier layer, e.g. TiN. Said conductive pattern is defined using at least one metallisation level, like e.g. the fourth and the fifth metallisation level in a CMOS or a BICMOS process. Said substrate can be provided with or without a ground contact to the substrate. This ground contact can be located at the backside and/or at the topside of the substrate. Said device further comprises a semi-transparent screening layer located in the substrate near or at the interface of said substrate and said insulating layer and an electrical contact to said screening layer for applying a substantially zero potential. Said screening layer can be any highly doped layer formed in the substrate with a resistivity typically about $10^{-3}$ $\Omega$cm or below $10^{-3}$ $\Omega$cm. Furthermore, the thickness of said screening layer should be chosen such that its skin depth frequency is beyond a predetermined frequency region in order to guarantee transparency for the magnetic field, therefore said thickness is typically in the range from 0.1 $\mu$m to 2 $\mu$m.

As a first example of a conductive pattern a square spiral inductor with three turns is considered and depicted in figure 2 a) and 2 b). This inductor is formed in the third metallization level (31). To facilitate the connection, at one side of said inductor also the second metallization level (32) is used. A substrate contact is provided at the bottom of the substrate (35) and at the surface of the substrate, i.e. a highly doped p-type region (33), i.e. the source/drain region, formed in a medium doped p-type well region (34) which is formed in a lowly doped p-type silicon substrate (21). Said surface contact comprises a contacting area in the third metallization level (31); a second level via (30), i.e. a via short-circuiting the third and second metallization level; a first level via (29), i.e. a via short-circuiting the second and first metallization level (28); and a selective contact metallization level (27) in order to contact said highly doped p-type region (33). Said inductor is isolated from said substrate by a number of insulating layers: a LOCOS layer (22) and four inter- or intra-metal dielectric layers, particularly 4 oxide layers: (23), (24), (25) and (26).

It is obvious to a person skilled in the art that the invention is not limited to this particular inductor but one can easily construct similar configurations e.g. by changing the metallization layer(s) wherein said inductor is formed, by changing the number and/or thickness and/or composition of the insulating layers, by changing the contact region, by using an arbitrary highly doped surface region, i.e. said highly doped surface region can either be an n-type or a p-type region dependent on the type of the substrate, or by changing the dimensions of the inductor. In figure 2 c) the frequency dependence of the characteristic impedance of such an inductor is presented for 3 cases. (11) is a measured curve of said inductor, said inductor being formed on a substrate without a semi-transparent screening layer (as e.g. in fig. 2 b)), while (12) is a simulated curve of said inductor. (13) is a simulated curve of an inductor being formed on a substrate with a semi-transparent screening layer (as e.g. in fig. 3). By the introduction of a semi-transparent screening layer, the dispersion of the frequency characteristics, particularly in the frequency region between 1 GHz and 10 GHz, is reduced significantly.

According to the present invention as an example (fig.3) a conductive pattern, i.e. a spiral inductor with three turns, is formed in the 3-th metallisation level (31) on a substrate, i.e. a lowly doped p-type silicon wafer (21), with oxide layers (22), (23), (24), (25) inbetween said wafer and said inductor. As a semi-transparent screening layer a highly doped p-type layer (36), i.e. with dopant concentrations typically between about $3X10^{19}$ cm$^{-3}$ and $3X10^{20}$ cm$^{-3}$, is formed in said substrate near the interface of said substrate and said oxide, i.e. typically at a distance from about 1 $\mu$m to 5 $\mu$m from said interface. Alternatively also a highly doped n-type layer can be formed. Said screening layer has a thickness of about 0.3 $\mu$m to 2 $\mu$m and is contacted using a surface substrate contact in order to supply a substantially zero potential. It is obvious to a person skilled in the art that the invention described in this and the following examples is not limited to a particular inductor but one can easily construct similar configurations e.g. by changing the metallization layer(s) wherein said inductor is formed, by changing the number and/or thickness and/or composition of the insulating layers, by changing the contact region by using an arbitrary highly doped surface region, i.e. said highly doped surface region can either be a n-type or a p-type region dependent on the type of the substrate, by changing the dimensions of the inductor.

According to the present invention as an example (fig.4) a conductive pattern, i.e. a spiral inductor with three turns, is formed in the 3-th metallisation level (31) on a substrate, i.e. a lowly doped p-type silicon wafer (21), with oxide layers (22), (23), (24), (25) inbetween said wafer and said inductor. As a semi-transparent screening layer a highly doped p-type surface layer (33), i.e. a source/drain layer with dopant concentrations typically between about $3X10^{19}$ cm$^{-3}$ and $3X10^{20}$ cm$^{-3}$, is formed in said substrate at the interface of said substrate and said oxide. Alternatively also a highly doped n-type layer can be formed. Said screening layer has a thickness of about 0.2 $\mu$m to 2 $\mu$m and is contacted using a surface substrate contact in order to supply a substantially zero potential. In a bipolar or a BICMOS process also the emitter or base layer can be used as a screening layer.

In an embodiment of the invention a device is disclosed comprising a semi-transparent screening layer located on the substrate near or at the interface of said substrate and said insulating layer and an electrical contact to said screening layer for applying a substantially zero potential. Said screening layers can be any highly conductive thin layer formed on the substrate with a resistivity typically below $10^{-3}$ $\Omega$cm like e.g. a thin metal layer or a highly doped polysilicon layer. Furthermore, the thickness of said screening layer should be chosen such that its skin depth frequency is beyond a predetermined frequency region in order to guarantee transparency for the magnetic field, therefore in case a metal layer is used as a screening layer, said thickness is typically in the range of 0.3 $\mu$m or below.

According to the present invention as an example (fig.5) a conductive pattern, i.e. a spiral inductor with three turns, is formed in the 3-th metallisation level (31) on a substrate, i.e. a lowly doped p-type silicon wafer (21), with oxide layers (22), (23), (24), (25) inbetween said wafer and said inductor. As a semi-transparent screening layer a highly doped p-type polysilicon layer (51), i.e. with dopant concentrations typically between about $3X10^{19}$ cm$^{-3}$ and $3X10^{20}$ cm$^{-3}$, is formed on said substrate near the interface of said substrate and said oxide, i.e. said polysilicon layer is formed on a LOCOS layer (22). Said screening layer has a thickness of about 0.3 $\mu$m to 1 $\mu$m and is contacted using a surface contact in order to supply a substantially zero potential. It is obvious to a person skilled in the art that the invention described in this and the following examples is not limited to a particular inductor but one can easily construct similar configurations e.g. by changing the metallization layer(s) wherein said inductor is formed, by changing the number and/or thickness and/or composition of the insulating layers between said inductor an said semi-transparent screening layer, by changing the dimensions of the inductor.

According to the present invention as an example (fig.6) a conductive pattern, i.e. a spiral inductor with three turns, is formed in the 3-th metallisation level (31) on a substrate, i.e. a lowly doped p-type silicon wafer (21), with oxide layers (22), (23), (24), (25) inbetween said wafer and said inductor. As a semi-transparent screening layer a thin metal layer (28), i.e. the first metallization layer composed of Aluminum, is formed on said substrate near the interface of said substrate and said oxide, i.e. said metal layer is formed on the intrametal dielectric (23). Said screening layer has a thickness of about 0.3 $\mu$m and is contacted using a surface contact in order to supply a substantially zero potential.

In an aspect of the invention a method is disclosed for shifting the frequency transition region of a conductive pattern beyond a predetermined frequency region, said conductive pattern being formed on a lossy substrate with at least one insulating layer inbetween said conductive pattern and said substrate, wherein said shift of said transition region is accomplished by the introduction of a semi-transparent screening layer, said screening layer being located near or at the interface of said substrate and said insulating layer, and wherein a substantially zero potential is applied to said screening layer. Said conductive pattern is formed on a substrate with at least one insulating layer inbetween said conductive pattern and said substrate. Said substrate can be a semiconductive wafer or slice, e.g. a doped silicon wafer with or without a doped epitaxial layer. Said substrate has a specific resistivity which can be between 10 m$\Omega$cm and 1 k$\Omega$cm, but preferably between 10 $\Omega$cm and 100 $\Omega$cm. Said insulating layer can be at least one oxide layer or a nitride layer or a layer of a low permittivity dielectric like e.g. a BCB layer or a SILK layer or a combination of these layers. Said conductive pattern can be composed of a metal like e.g. Al or Cu or Au or an alloy of one of the aforementioned metals. Said conductive pattern can also comprise a highly conductive layer, e.g. a metal layer, and a barrier layer, e.g. TiN. Said conductive pattern is defined using at least one metallisation level, like e.g. the fourth and the fifth metallisation level in a CMOS or a BICMOS process. Said substrate can be provided with or without a ground contact to the substrate. This ground contact can be located at the backside and/or at the topside of the substrate. Said shift of the transition region is accomplished by the introduction of a semi-transparent screening layer, i.e. a layer which forms an electrical wall and therefore a screening layer for the electric field and which is transparent for the magnetic field, in said substrate. Said screening layer is located in the substrate near or at the interface of said substrate and said insulating layer and an electrical contact is provided to said screening layer for applying a substantially zero potential. Said screening layer can be any highly doped layer formed in the substrate with a resistivity typically about 10$^{-3}$ $\Omega$cm or below 10$^{-3}$ $\Omega$cm. Furthermore, the thickness of said screening layer should be chosen such that its skin depth frequency is beyond a predetermined frequency region in order to guarantee transparency for the magnetic field, therefore said thickness is typically in the range from 0.1 $\mu$m to 2 $\mu$m. Said highly doped layer can be a highly doped buried layer or a highly doped surface layer like e.g. a source/drain layer in a CMOS process.

According to the method of the present invention, alternatively said screening layer can be located on the substrate near or at the interface of said substrate and said insulating layer and an electrical contact is provided to said screening layer for applying a substantially zero potential. Said screening layer can be any highly conductive layer formed on said substrate with a resistivity typically below 10$^{-3}$ $\Omega$cm. Furthermore, the thickness of said screening layer should be chosen such that its skin depth frequency is beyond a predetermined frequency region in order to guarantee transparency for the magnetic field. In case said highly conductive layer is a highly doped polysilicon layer, its thickness is typically in the range from 0.1 $\mu$m to 1 $\mu$m, while in case said highly conductive layer is a thin metal layer, its thickness is typically in the range below 0.3 $\mu$m.

## Claims

1. A device for reducing the dispersion of frequency characteristics of a conductive pattern in a predetermined frequency region comprising:

   a conductive pattern;
   a lossy substrate, said conductive pattern being formed on said substrate;
   at least one insulating layer between said conductive pattern and said substrate; characterised in that, said device further comprises a semi-transparent screening layer and an electrical contact for applying a substantially zero potential to said layer.

2. A device as recited in claim 1, where said substrate is at least a part of either one of a Si or a SiGe or a GaAs wafer and where the resistivity of said substrate is in the range from 10 $\Omega$cm to 100 $\Omega$cm.

3. A device as recited in claim 1, where said predetermined frequency region is in the range from 1 GHz to 10 GHz.

4. A device as recited in claim 1, where each insulating layer is composed of at least one dielectric material selected from the group comprising an oxide, a nitride, BCB and SILK.

5. A device as recited in claim 1, where said conductive pattern is an inductor.

6. A device as recited in claim 1, where said semi-transparent layer is a layer formed in said substrate, said layer having a resistivity of 1 m$\Omega$cm or below 1 m$\Omega$cm.

7. A device as recited in claim 6, where said semi-transparent layer is a doped surface layer with a thickness in the range from 0.1 $\mu$m to 2 $\mu$m.

8. A device as recited in claim 6, where said semi-transparent layer is a doped buried layer with a thickness in the range from 0.1 µm to 2 µm and where the distance between said layer and the interface of said insulating layer and said substrate is in the range from 1 µm to 5 µm.

9. A device as recited in claim 1, where said semi-transparent layer is a layer formed on said substrate, said layer having a resistivity of 1 mΩcm or below 1 mΩcm.

10. A device as recited in claim 9, where said semi-transparent layer is a doped polysilicon layer with a thickness in the range from 0.1 µm to 1 µm.

11. A device as recited in claim 9, where said semi-transparent layer is a metal layer with a thickness of 0.3 µm or below 0.3 µm.

12. A method for shifting the frequency transition region of a conductive pattern beyond a predetermined frequency region, said conductive pattern being formed on a lossy substrate with at least one insulating layer inbetween said conductive pattern and said substrate, wherein said shift of said transition region is accomplished by the introduction of a semi-transparent screening layer, said screening layer being located near or at the interface of said substrate and said insulating layer, and wherein a substantially zero potential is applied to said screening layer.

13. A method as recited in claim 12, wherein said substrate is at least a part of either one of a Si or a SiGe or a GaAs wafer and wherein the resistivity of said substrate is in the range from 10 Ωcm to 100 Ωcm.

14. A method as recited in claim 12, where said predetermined frequency region is in the range from 1 GHz to 10 GHz.

15. A method as recited in claim 12, where each insulating layer is composed of at least one dielectric material selected from the group comprising an oxide, a nitride, BCB and SILK.

16. A method as recited in claim 12, wherein said conductive pattern is an inductor.

17. A method as recited in claim 12, wherein said semi-transparent layer is formed in said substrate, said layer having a resistivity of 1 mΩcm or below 1 mΩcm.

18. A method as recited in claim 17, wherein said semi-transparent layer is a doped surface layer with a thickness in the range from 0.1 µm to 2 µm.

19. A method as recited in claim 17, wherein said semi-transparent layer is a doped buried layer with a thickness in the range from 0.1 µm to 2 µm and wherein the distance between said layer and the interface of said insulating layer and said substrate is in the range from 1 µm to 5 µm.

20. A method as recited in claim 12, where said semi-transparent layer is formed on said substrate, said layer having a resistivity of 1 mΩcm or below 1 mΩcm.

21. A method as recited in claim 20, wherein said semi-transparent layer is a doped polysilicon layer with a thickness in the range from 0.1 µm to 1 µm.

22. A method as recited in claim 20, wherein said semi-transparent layer is a metal layer with a thickness of 0.3 µm or below 0.3 µm.

# Figure 1

**a)**

**b)**

## Figure 2 a)

## Figure 2 b)

EP 0 940 849 A1

Figure 2 c)

12

Figure 3

Figure 4

Figure 5

## Figure 6

## Figure 7

EP 0 940 849 A1

## EUROPEAN SEARCH REPORT

European Patent Office

Application Number

EP 98 87 0046

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 567 016 A (SUMITOMO ELECTRIC INDUSTRIES) 27 October 1993 | 1,12 | H01L23/66 H01L23/552 |
| Y | * column 11, line 38 - column 13, line 41; figures 10,11 * | 2-11, 13-22 | |
| X | US 3 990 102 A (OKUHARA SHINZI ET AL) 2 November 1976 | 1,12 | |
| Y | * column 4, line 3 - column 5, line 29; figures 3-5 * | 2-11, 13-22 | |
| X | US 5 347 086 A (POTTER CURTIS N ET AL) 13 September 1994 | 1,12 | |
| Y | * column 3, line 38 - column 4, line 60; figure 2 * | 1-22 | |
| Y | GB 2 168 857 A (INT STANDARD ELECTRIC CORP) 25 June 1986 * column 1, line 121 - column 2, line 99; figure 3 * | 1-22 | |
| A | EP 0 764 995 A (HUGHES AIRCRAFT CO) 26 March 1997 * the whole document * | 1-22 | TECHNICAL FIELDS SEARCHED (Int.Cl.6) H01L H01F H05K |
| A | EP 0 592 002 A (MITSUBISHI ELECTRIC CORP) 13 April 1994 * the whole document * | 1-22 | |

The present search report has been drawn up for all claims

| Place of search | Date of completion of the search | Examiner |
|---|---|---|
| MUNICH | 6 August 1998 | Torti, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

15

## ANNEX TO THE EUROPEAN SEARCH REPORT
## ON EUROPEAN PATENT APPLICATION NO.

EP 98 87 0046

This annex lists the patent family members relating to the patent documents cited in the above-mentioned European search report.
The members are as contained in the European Patent Office EDP file on
The European Patent Office is in no way liable for these particulars which are merely given for the purpose of information.

06-08-1998

| Patent document cited in search report | | Publication date | Patent family member(s) | | Publication date |
|---|---|---|---|---|---|
| EP 0567016 | A | 27-10-1993 | JP | 6005593 A | 14-01-1994 |
| | | | DE | 69300615 D | 16-11-1995 |
| | | | DE | 69300615 T | 25-07-1996 |
| | | | US | 5348792 A | 20-09-1994 |
| | | | EP | 0605399 A | 06-07-1994 |
| | | | US | 5353499 A | 11-10-1994 |
| US 3990102 | A | 02-11-1976 | JP | 1115444 C | 29-09-1982 |
| | | | JP | 51003786 A | 13-01-1976 |
| | | | JP | 57000652 B | 07-01-1982 |
| | | | JP | 1157011 C | 15-07-1983 |
| | | | JP | 51011581 A | 29-01-1976 |
| | | | JP | 57048857 B | 19-10-1982 |
| US 5347086 | A | 13-09-1994 | NONE | | |
| GB 2168857 | A | 25-06-1986 | US | 4673904 A | 16-06-1987 |
| | | | FR | 2573272 A | 16-05-1986 |
| | | | JP | 61210696 A | 18-09-1986 |
| | | | JP | 62119807 A | 01-06-1987 |
| | | | JP | 62120058 A | 01-06-1987 |
| | | | US | 4816967 A | 28-03-1989 |
| EP 0764995 | A | 26-03-1997 | US | 5581217 A | 03-12-1996 |
| | | | JP | 9172292 A | 30-06-1997 |
| EP 0592002 | A | 13-04-1994 | JP | 6125208 A | 06-05-1994 |
| | | | DE | 69307248 D | 20-02-1997 |
| | | | DE | 69307248 T | 07-08-1997 |
| | | | US | 5352998 A | 04-10-1994 |

EPO FORM P0459

For more details about this annex : see Official Journal of the European Patent Office, No. 12/82